**Europäisches Patentamt**

**European Patent Office**

**Office européen des brevets**

(19)

(11) Veröffentlichungsnummer: **0 119 397**
**A2**

(12) # EUROPÄISCHE PATENTANMELDUNG

(21) Anmeldenummer: **84100479.9**

(22) Anmeldetag: **18.01.84**

(51) Int. Cl.³: **H 03 D 7/16**

(30) Priorität: **16.03.83 DE 3309352**

(43) Veröffentlichungstag der Anmeldung: **26.09.84**
**Patentblatt 84/39**

(84) Benannte Vertragsstaaten: **AT BE DE NL**

(71) Anmelder: **ROBERT BOSCH GMBH, Postfach 50, D-7000 Stuttgart 1 (DE)**

(72) Erfinder: **Wischmann, Ulrich, Dipl.-Ing., Gravelottestrasse 7, D-1000 Berlin 41 (DE)**

(74) Vertreter: **Schmidt, Hans-Ekhardt, Robert Bosch GmbH Geschäftsbereich Elektronik Patent- und Lizenzabteilung Forckenbeckstrasse 9-13, D-1000 Berlin 33 (DE)**

(54) Umsetzeranordnung für phasenverkoppelte Trägerfrequenz-Übertragungssysteme.

(57) Es wird eine Umsetzeranordnung vorgeschlagen, die zur Phasenverkopplung in Trägerfrequenz-Übertragungssystemen dient. Die Umsetzeranordnung umfaßt für jeden Eingangskanal einen Doppelumsetzer aus Eingangs- und Ausgangsumsetzer. Gemäß der Erfindung soll wenigstens für alle Ausgangsumsetzer (28, 63) der Umsetzeranordnung ein einziger Bezugsfrequenzgenerator (50) vorhanden sein. Die von einer PLL-Oszillatorschaltung (40) des Ausgangsumsetzers abgegebene Oszillatorfrequenz ($f_o$) wird mit der vom Eingangsumsetzer abgeleiteten Zwischenfrequenz ($f_Z$) in einem ersten Mischer (21) einer Mischschaltung (13) und einem zweiten Mischer (33) des Ausgangsumsetzers gemischt. Die Ausgangsfrequenz ($f_v'$) des ersten Mischers wird einem Hauptfrequenzteiler (43) der PLL-Oszillatorschaltung zugeführt, und die Ausgangsfrequenz des zweiten Mischers bildet die Ausgangsfrequenz des Doppelumsetzers.

EP 0 119 397 A2

5/83
EK/PLI Scht/Li
14. 3. 1983

ROBERT BOSCH GMBH, 7000 Stuttgart 1

Umsetzeranordnung für phasenverkoppelte
Trägerfrequenz-Übertragungssysteme

## Stand der Technik

Die Erfindung geht von einer Umsetzeranordnung nach der
Gattung des Hauptanspruchs aus.

Es ist schon eine Umsetzeranordnung für Fernseh- und UKW-
Gemeinschaftsantennenanlagen bekannt (BOSCH, Technische
Informationen, ZF-Umsetzer für TV und UKW, Impressum:
EK-VKD 8 699 914 115, 81905), die Doppelumsetzer enthält,
von denen ein Eingangsumsetzer einen Eingangskanal in eine
genormte Zwischenfrequenz und ein Ausgangsumsetzer die
Zwischenfrequenz in einen gewünschten Ausgangskanal umsetzt.
Durch die Doppelumsetzung ergibt sich eine hohe Übertragungsqualität. Eingangs- und Ausgangsumsetzer enthalten je eine
PLL (Phase locked-loop)-Oszillatorschaltung mit einem eigenen
Quarzoszillator als Bezugsfrequenzoszillator, von dem eine
für den Phasenvergleich benötigte Referenzfrequenz abgeleitet
wird. Die andere Frequenz für den Phasenvergleich, im folgenden Vergleichsfrequenz genannt, wird beim Eingangsumsetzer
und Ausgangsumsetzer aus der PLL-Oszillatorfrequenz durch
Frequenzteilung erhalten.

Bei dieser bekannten Umsetzeranordnung sind die Phasenlagen
der einzelnen Ausgangskanäle zueinander nicht konstant. Es
ist auch schon vorgeschlagen worden, die gegenseitige Phasenlage aller Frequenzen konstant zu halten, indem in den Ausgangsumsetzern die Ausgangsfrequenz mit einer entsprechenden,
von einem Frequenzrastergenerator (Comb-Generator) gelieferten Bezugsfrequenz verglichen wird.

...

## Vorteile der Erfindung

Die erfindungsgemäße Umsetzeranordnung mit den kennzeichnenden Merkmalen des Anspruchs 1 hat den Vorteil, daß in einem Übertragungssystem mit einer größeren Zahl von Ausgangsumsetzern die Ausgangsfrequenzen $f_{A1}$ ... in einem wählbaren festen Phasenverhältnis zu einer allen Ausgangsumsetzern zugeführten festen Bezugsfrequenz $f_B$ stehen, wobei der Phasenvergleich nur im Ausgangsumsetzer stattfindet. Dadurch verringert sich der technische Aufwand für die Phasenverkopplung.

Als weiterer Vorteil ist anzusehen, daß auch in dem Fall, wenn die Eingangsfrequenzen $f_{E1}$ ... driften, die von dem Eingangsumsetzer abgegebene Zwischenfrequenz zwar ebenfalls driftet, daß aber durch die Verwendung des zusätzlichen Mischers zwischen Eingangsumsetzer und Ausgangsumsetzer die Ausgangsfrequenz des Mischers nicht mitdriftet. Besonders vorteilhaft ist eine erfindungsgemäße Umsetzeranordnung, bei der der Ausgangsumsetzer als einfacher Umsetzer verwendet wird, wobei der dem Ausgang des spannungsgesteuerten Oszillators zugeordnete Ausgang und der dem Eingang des Hauptfrequenzteilers zugeordnete Eingang des Ausgangsumsetzers durch eine elektrisch leitende Brücke überbrückt sind. Auf diese Weise vereinfacht sich die Herstellung und Lagerhaltung für Ausgangsumsetzer für phasenverkoppelte Systeme und einfache Umsetzer.

## Zeichnung

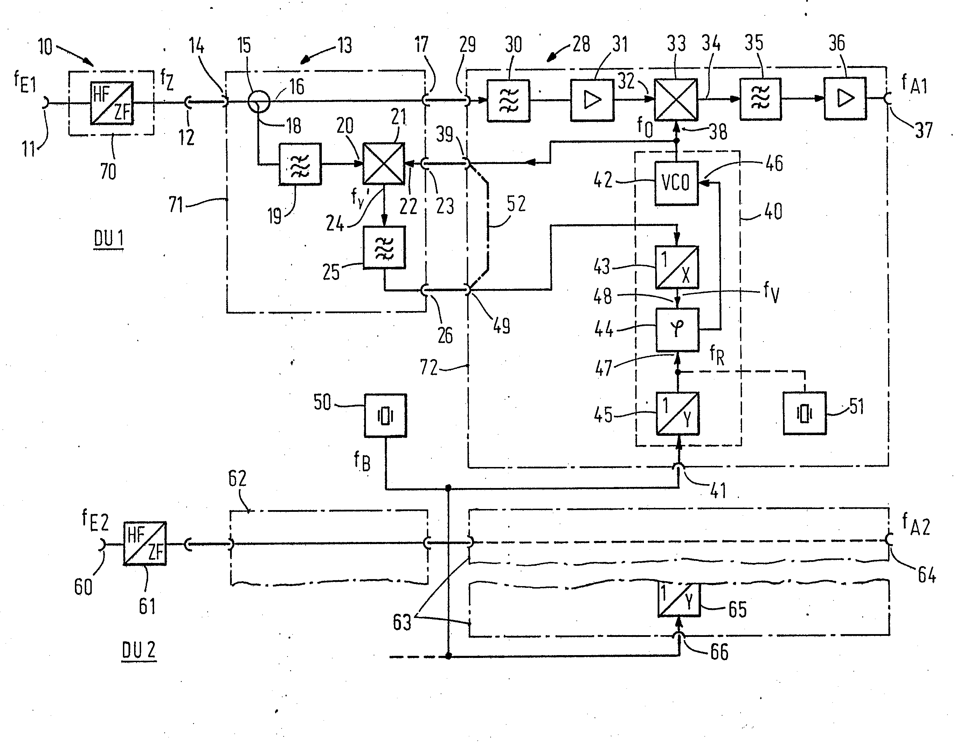

Ein Ausführungsbeispiel der Erfindung ist in der Zeichnung an Hand einer Figur dargestellt und in der nachfolgenden Beschreibung näher erläutert.

Beschreibung der Erfindung

Das in der einzigen Figur der Zeichnung gezeigte vereinfachte
Blockschaltbild einer erfindungsgemäßen Umsetzeranordnung weist
einen ersten Doppelumsetzer DU1 mit einem Eingangsumsetzer 10
auf, der einen Eingang 11 und einen Ausgang 12 hat. Der erste
Eingangsumsetzer ist in bekannter Weise mit einem Mischer und
einer PLL(Phase locked-loop)-Oszillatorschaltung ausgerüstet,
deren Frequenz quarzstabilisiert ist.

An den Ausgang 12 des Eingangsumsetzers schließt sich eine
Mischschaltung 13 an, deren erster Eingang 14 mit einem Eingang
einer Kopplungsvorrichtung 15, das ist zum Beispiel ein Richtkoppler, verbunden ist. Ein erster Ausgang 16 der Kopplungsvorrichtung bildet gleichzeitig einen ersten Ausgang 17 der Mischschaltung. Ein zweiter Ausgang 18 (Stich) der Kopplungsvorrichtung 15 ist über ein erstes Bandpaßfilter 19 mit einem ersten
Eingang 20 eines ersten Mischers 21 verbunden, dessen zweiter
Eingang mit 22 bezeichnet ist. Der Eingang 22 des Mischers
bildet gleichzeitig einen zweiten Eingang 23 der Mischschaltung 13. Ein Ausgang 24 des Mischers 21 steht über ein zweites
Bandpaßfilter 25 mit einem zweiten Ausgang 26 der Mischschaltung
in Verbindung.

An die Mischschaltung 13 schließt sich ein Ausgangsumsetzer 28
an, dessen erster mit dem ersten Ausgang 17 verbundener Eingang 29 über ein ZF-Filter 30 und einen ZF-Verstärker 31 mit
einem ersten Eingang 32 eines zweiten Mischers 33 verbunden ist.
Ein Ausgang 34 des zweiten Mischers steht über ein Bandpaßfilter 35 mit einem Verstärker 36 in Verbindung, dessen Ausgang
einen ersten Ausgang 37 des Ausgangsumsetzers 28 bildet. Ein
zweiter Eingang 38 des zweiten Mischers 33 steht erstens mit
einem mit dem zweiten Eingang 23 der Mischschaltung 13 verbundenen zweiten Ausgang 39 des Ausgangsumsetzers 28 und zweitens

...

0119397

mit dem Oszillatorausgang einer PLL-Oszillatorschaltung 40 (vgl. durch gestrichelte Linien umrahmter Schaltungsteil) in Verbindung, deren Bezugsfrequenz-Eingang einen zweiten Eingang 41 des Ausgangsumsetzers bildet.

Zu der PLL-Oszillatorschaltung 40 gehören ein spannungsgesteuerter Oszillator 42 (VCO), ein Hauptfrequenzteiler 43, eine Phasenvergleichsschaltung 44 und ein weiterer Frequenzteiler 45. Ein Steuereingang 46 des spannungsgesteuerten Oszillators ist mit einem Ausgang der Phasenvergleichsschaltung 44 verbunden. Zwischen einem ersten Eingang 47 der Phasenvergleichsschaltung und dem zweiten Eingang 41 des Ausgangsumsetzers liegt der weitere Frequenzteiler 45 und zwischen einem zweiten Eingang 48 der Phasenvergleichsschaltung und einem dritten Eingang 49 des Ausgangsverstärkers der Hauptfrequenzteiler 43. Der dritte Eingang 49 ist mit dem zweiten Ausgang 26 der Mischschaltung 13 und der zweite Eingang 41 des Ausgangsumsetzers mit einem Bezugsfrequenzgenerator 50 verbunden.

In der Figur ist unterhalb des vorstehend beschriebenen Doppelumsetzers DU1 ein weiterer Doppelumsetzer DU2 von mehreren Doppelumsetzern schematisch gezeigt, dessen Eingang 60 mit einem zweiten Eingangsumsetzer 61 verbunden ist, an den sich eine weitere Mischschaltung 62 anschließt, auf die ein zweiter Ausgangsumsetzer 63 folgt, dessen Ausgang mit 64 bezeichnet ist.

Die genannten Baustufen 61 bis 63 sind in gleicher Weise wie die Baustufen der weiter oben beschriebenen Umsetzeranordnung aufgebaut. Ein weiterer Frequenzteiler 65 des zweiten Ausgangsumsetzers 63 ist ebenfalls mit dem Bezugsfrequenzgenerator 50 verbunden.

...

Die Wirkungsweise der vorstehend beschriebenen Umsetzeranordnungen ist folgende.

In dem Eingangsumsetzer 10 des zum Beispiel für die UHF-VHF-
Umsetzung vorgesehenen Fernseh-Doppelumsetzers aus Eingangsumsetzer, Mischschaltung 13 und Ausgangsumsetzer 28 wird die
dem Eingang 11 zugeführte Eingangsfrequenz $f_{E1}$, das ist beispielsweise eine Frequenz zwischen 470 und 860 MHz, in eine
Zwischenfrequenz $f_Z$ von zum Beispiel 38,9 MHz für den Bildträger umgesetzt. Die am Ausgang 12 des Eingangsumsetzers
vorhandene Zwischenfrequenz $f_Z$ gelangt über die Kopplungsvorrichtung 15 der Mischschaltung 13 an deren Ausgang 17 und
von dort über das Zwischenfrequenzfilter 30, mit welchem die
Zwischenfrequenz $f_Z$ von Störanteilen befreit wird, und den
ZF-Verstärker 31 an den ersten Eingang 32 des zweiten
Mischers 33. Die für die Mischung benötigte Oszillatorfrequenz $f_O$ liefert der spannungsgesteuerte Oszillator 42 der
PLL-Oszillatorschaltung 40. Durch die Mischung entsteht eine
Frequenz, die nach einer Aussiebung mittels des Bandpaßfilters 35 und nach anschließender Verstärkung durch den Verstärker 36 als Ausgangsfrequenz $f_{A1}$ am ersten Ausgang 37 zur
Verfügung steht.

Anstatt wie bei den üblichen PLL-Oszillatorschaltungen für
Fernseh-Doppelumsetzer die Oszillatorfrequenz $f_O$ selbst mittels
eines Frequenzteilers zu teilen und mit der Referenzfrequenz $f_R$
zu vergleichen, wird die Oszillatorfrequenz $f_O$ über den zweiten
Ausgang 39 des Ausgangsumsetzers 28 dem zweiten Eingang 23 der
Mischschaltung 13 zugeführt. In dem ersten Mischer 21 wird die
Oszillatorfrequenz $f_O$ mit der über die Kopplungsvorrichtung 15
ausgekoppelten und in einem Bandpaßfilter 19 von Störanteilen
befreiten Zwischenfrequenz $f_Z$ gemischt. Die dadurch erhaltene
Vergleichsfrequenz $f_V'$ wird nach dem Passieren des zweiten
Bandpaßfilters 25 in dem Hauptfrequenzteiler 43 im Verhältnis
1 : X auf eine Vergleichsfrequenz $f_V$ geteilt und in der Phasenvergleichsschaltung 44 mit der Referenzfrequenz $f_R$ verglichen.

...

Die Referenzfrequenz liefert der mit dem Bezugsfrequenzgenerator 50 verbundene weitere Frequenzteiler 45, der ein Teilerverhältnis von 1 : Y hat.

Die Teilerverhältnisse von Hauptfrequenzteiler 43 und weiterem Frequenzteiler 45 sind derart bemessen, daß bei einer vorgegebenen Bezugsfrequenz $f_B$ und bei Frequenz- und Phasengleichheit von Vergleichsfrequenz $f_V$ und Referenzfrequenz $f_R$ ein Einrasten der PLL-Oszillatorschaltung stattfindet. Dann ergeben die von dem spannungsgesteuerten Oszillator 42 abgegebene Oszillatorfrequenz $f_O$ und die Zwischenfrequenz $f_Z$ nach Mischung in dem zweiten Mischer 33 eine Ausgangsfrequenz $f_{A1}$, die ebenso wie die Ausgangsfrequenzen $f_{A2}$ ... weiterer Doppelumsetzer einem für alle Ausgangsfrequenzen geltenden vorgegebenen Frequenzraster angehört.

Während allen Ausgangsumsetzern 28, 63 ... dieselbe Bezugsfrequenz $f_B$ zugeführt wird und damit eine feste Phasenverkopplung der Ausgangsfrequenzen erzielt wird, ist eine derartige Verkopplung bei den Eingangsumsetzern 10, 61 ... nicht vorgesehen. Die Eingangsumsetzer enthalten je einen eigenen quarzstabilen Bezugsfrequenzgenerator. In der Figur ist noch angedeutet, daß der zweite Ausgang 39 des Ausgangsumsetzers 28 und der dritte Eingang 49 gegebenenfalls durch eine elektrisch leitende Brücke 52 überbrückt werden können. Dann kann der Ausgangsumsetzer 28 als normaler Umsetzer für nichtphasenverkoppelte Systeme verwendet werden, wobei der Umsetzer nur in diesem Fall einen eigenen Bezugsfrequenzgenerator 51 aufweist, während der Bezugsfrequenzgenerator 50, der zweite Eingang 41 und der weitere Frequenzteiler 45 entfallen können.

...

Eingangsumsetzer, Mischschaltung und Ausgangsumsetzer der
Umsetzeranordnung sind vorzugsweise in quaderförmigen
Gehäusen 70, 71, 72 (in der Figur durch strichpunktierte
Linien angedeutet) untergebracht, die aneinanderreihbar
sind, wobei die elektrischen Anschlüsse (Eingänge und
Ausgänge) vorzugsweise als Steckverbinder ausgebildet
sind. Die Brücke 52 kann - wie in der Figur gezeigt -
innerhalb des Gehäuses des Ausgangsumsetzers oder auch an
der Außenseite des Gehäuses angeordnet sein. Gegebenenfalls kann die Mischschaltung 13 in dem Gehäuse 72 des
Ausgangsumsetzers 28 untergebracht sein.

Die Ausgangsumetzer 28, 63 ... können als ZF-VHF(UHF)-
Umsetzer für ZF-Kabelsender (Modulatoren) verwendet werden, ohne daß deren Bildträger aus der Bezugsfrequenz
abgeleitet werden muß.

5/83
EK/PLI Scht/Li
14. 3. 1983

ROBERT BOSCH GMBH, 7000 Stuttgart 1

Ansprüche

1. Umsetzeranordnung für phasenverkoppelte Trägerfrequenz-Übertragungssysteme, bei der für jeden Eingangskanal eine aus Eingangsumsetzer und Ausgangsumsetzer bestehende Doppelumsetzer-Anordnung vorgesehen ist, deren Eingangsumsetzer einen Eingangskanal in einen für alle Doppelumsetzer gleichen Zwischenfrequenzkanal und deren Ausgangsumsetzer den Zwischenfrequenzkanal unter Verwendung einer PLL-Oszillatorschaltung in einen wählbaren Ausgangskanal umsetzt, der zu einem für alle Ausgangskanäle vorgegebenen Frequenzraster gehört, dadurch gekennzeichnet, daß wenigstens für alle Ausgangsumetzer (28, 63) der Umsetzeranordnung ein einziger Bezugsfrequenzgenerator (50) vorgesehen ist und daß die einem zweiten Mischer (33) des Ausgangsumsetzers zugeführte Oszillatorfrequenz ($f_O$) der PLL-Oszillatorschaltung (40) einem zweiten Eingang (22) eines ersten Mischers (21) einer Mischschaltung (13) zugeführt wird, dessen erster Eingang (20) die am Eingang (14) der Mischschaltung liegende Zwischenfrequenz ($f_Z$) nach Filterung zugeführt wird und dessen Ausgangsfrequenz ($f_V'$) dem Hauptfrequenzteiler (43) der PLL-Oszillatorschaltung des Ausgangsumsetzers zugeführt wird, wobei das Teilerver-hältnis des Hauptfrequenzteilers so gewählt ist, daß die von dem ersten Mischer gelieferte Ausgangsfrequenz, die etwa gleich der Ausgangsfrequenz ($f_A$) des Ausgangsumsetzers ist, nach Teilung in dem Hauptfrequenzteiler eine Vergleichs-frequenz ($f_V$) ergibt, die gleich einer von dem Bezugsfrequenzgenerator (50) abgeleiteten Referenzfrequenz ($f_R$) ist.

...

2. Umsetzeranordnung nach Anspruch 1, gekennzeichnet durch die Anwendung des Ausgangsumsetzers (28) als einfacher Umsetzer, wobei der dem Ausgang des spannungsgesteuerten Oszillators (42) zugeordnete zweite Ausgang (39) und der dem Eingang des Hauptfrequenzteilers (43) zugeordnete dritte Eingang (49) durch eine elektrisch leitende Brücke (52) überbrückt ist.

3. Umsetzeranordnung nach Anspruch 2, dadurch gekennzeichnet, daß der Ausgangsumsetzer (28) einen eigenen, wahlweise zuschaltbaren Bezugsfrequenzgenerator (51) aufweist.

4. Umsetzeranordnung nach Anspruch 1, dadurch gekennzeichnet, daß zwischen einem ersten Eingang (14) der Mischschaltung (13) und einem ersten Ausgang (17) eine Kopplungsvorrichtung (15) liegt, deren zweiter Ausgang (18) über ein erstes Bandpaßfilter (19) mit einem ersten Eingang (20) des ersten Mischers (21) verbunden ist, dessen zweiter Eingang (22) mit dem zweiten Ausgang (39) des Ausgangsumsetzers (28) und dessen Ausgang (24) mit dem dritten Eingang (49) des Ausgangsumsetzers verbunden ist.

5. Umsetzeranordnung nach Anspruch 1 oder 4, dadurch gekennzeichnet, daß der Eingangsumsetzer (10), die Mischschaltung (13) und der Ausgangsumsetzer (28) in Einzelgehäusen (70, 71, 72) untergebracht sind.

6. Umsetzeranordnung nach Anspruch 5, dadurch gekennzeichnet, daß die Gehäuse (70, 71, 72) über elektrische Steckverbinder miteinander verbunden sind.

7. Umsetzeranordnung nach einem der Ansprüche 1 bis 4, dadurch gekennzeichnet, daß die Mischschaltung (13) in dem Gehäuse (72) des Ausgangsumsetzers (28) enthalten ist.